Europäisches Patentamt

European Patent Office

Office européen des brevets

(11) Publication number: **0 178 341**
**B1**

(12) EUROPEAN PATENT SPECIFICATION

(45) Date of publication of patent specification: **07.03.90**

(21) Application number: **84112504.0**

(22) Date of filing: **17.10.84**

(51) Int. Cl.⁵: **B 07 C 5/342, G 01 R 29/033**

(54) Process and apparatus for sorting samples.

(43) Date of publication of application:
**23.04.86 Bulletin 86/17**

(45) Publication of the grant of the patent:
**07.03.90 Bulletin 90/10**

(84) Designated Contracting States:
**DE FR GB IT**

(56) References cited:
**GB-A-2 013 875**
**US-A-3 487 222**
**US-A-4 057 146**

**NUCLEAR INSTRUMENTS AND METHODS, vol.
75, no. 1, 1st November 1969, pages 117-120,
North-Holland Publishing CO.; L.B. ROBINSON
et al.: "An inexpensive gain stabilizer controlled
by a time-shared computer"**

**PATENTS ABSTRACTS OF JAPAN, vol. 5, no. 81
(P-63)753r, 1981; & JP - A - 56 26 246 (SATAKE
SEISAKUSHO K.K.) 13-03-1981**

(73) Proprietor: **Xeltron, S.A.**
**Apartado 6953**
**San José (CR)**

(72) Inventor: **Castaneda, Fernando**
**San Ramon de Très Rios**
**San José (CR)**

(74) Representative: **Glawe, Delfs, Moll & Partner**
**Patentanwälte**
**Rothenbaumchaussee 58 Postfach 2570**
**D-2000 Hamburg 13 (DE)**

Courier Press, Leamington Spa, England.

## Description

The invention relates to a process for sorting samples of a material, in which a pulse signal from each sample reaches a detector, where the signal then is electronically processed in a signal processing device to activate a sorting device if the signal has predetermined properties and where the gain of the device for processing the signal is adjustable by using peak values of the pulses. The invention also relates to an apparatus for performing the process.

In a large number of cases samples of material which move past a detector have to be sorted or otherwise investigated. For this reason some signal of the samples is taken up in the detector and further processed. Signals of this kind can be signals of visible light, ultraviolet light, infrared light, other electromagnetic radiation as e.g. X-rays, microwaves etc. Also ultrasonic signals could be used for these purposes.

An example of such a sorting machine is described in US—A—4 057 146 of the applicant.

This apparatus serves for sorting beans or grains. In this apparatus the beans or grains are moved one by one past a ring of detectors in which their colour is sampled. The signals of several detectors are combined in a photocell; the signals of the photocell are then electronically processed.

If one of the beans or grains has not the desired properties (is e.g. too small or has an unwanted colour), with a given delay a sorting device is activated, when the corresponding bean reaches this sorting device. This sorting device can be e.g. a stream of air which is produced by activating a solenoid.

One important problem with such a process or an apparatus is the fact, that the gain of the devices for electronically processing the signals has to be adjusted. This is particularly the case, if the conditions change with which the radiation signals or other signals reach the detector, e.g. due to a changing amount of dust on the detectors. Normally this gain has to be adjusted by hand which requires that a person is constantly watching the apparatus. In addition to that, there is always the chance of an error which will result in bad sorting results.

The object of the invention is to provide a process and an apparatus of the above mentioned kind which requires no manual adjustment of the gain.

This object is solved by a process in which the gain of the device for processing the signal is automatically and continuously controlled by measuring peak values of the pulses, by counting the pulses with pulse heights within a certain predetermined range, by counting the total number of pulses, and by readjusting the gain if the ratio of number of pulses within the predetermined range to the total number of pulses deviates from a predetermined ratio.

Automatic gain control (AGC) is known for e.g. from NUCLEAR INSTRUMENTS AND METHODS, Vol. 75, No. 1, 1 November 1969, pages 117 to 120, North-Holland Publishing Co.; L. B. ROBINSON et al.: "An inexpensive gain stabilizer controlled by a time-shared computer". With a device of this kind the gain can be controlled if one obtains for a given experiment a constant spectrum of pulses as is the case in nuclear spectroscopy. These pulses have different heights depending on the energy of the photon or particle responsible for the pulse. The energy and thus the pulse-height has a distribution around a centre energy or pulse-height which e.g. is Gaussian or Lorentzian. The line shape itself, however, remains constant during one experiment when data are accumulated. Because high-rate pulse-height analysis is concerned, one obtains good statistics with relatively small deviations from the theoretical curve. If the pulse distribution curve is shifted due to a small change in gain, this can be immediately detected because the distribution due to its good statistics remains unchanged in shape, but is only shifted to higher or lower energies.

Such a regular distribution of pulse-heights which remains constant for a longer period of time is not present when samples like beans or grains are measured and detected. Therefore the device which may be useful in nuclear spectroscopy cannot be used for adjusting the gain in a process for sorting samples of a material which differ in size and/or colour.

Automatic gain control is known also in radio and television receivers. This automatic gain, however, is operative only in connection with more or less continuous signals, e.g. more or less continuous steady oscillations. The amplified signals in such devices are averaged by integrating (if necessary after rectification); the corresponding DC signal is used for adjusting the gain.

Such a conventional automatic gain control can be used here. The total average signal will not be only a function of the single pulses or signals of single beans. It will also be a function of the total number of pulses of beans passing the apparatus within a given time. If the conventional system of automatic gain control would be used, the gain would be reduced if the number of beans or other objects to be sorted increases. This effect of course is not at all desired.

According to the inventive process and apparatus, the peak values of the pulses are measured. The pulses with pulse heights within a certain predetermined range are counted. Also the total number of pulses is counted. If the ratio of numbers of total pulses and pulses within the predetermined height range deviates from a predetermined value, the gain is adjusted.

Because it is easier to determine whether pulses exceed a predetermined level than to decide whether they fall into a predetermined range with two given boundaries, in an advantageous embodiment all pulses with heights above a predetermined magnitude are counted and compared with the total number of pulses.

If the pulses should fall in a range between 5 V and 10 V, it would be possible to count 256 pulses. If less than 128 pulses have a pulse height exceeding 5 V, the gain is increased; if more than 128 pulses have this height, the gain is decreased. After 256 pulses have been counted, the whole procedure starts again.

This process can be controlled by a microprocessor. In this case e.g. after switching on the gain can be doubled in the first step, then reduced by a factor of 1,5 in the next step, if the increase was too large, thus asymptotically reaching the ideal value. If conditions (e.g. dust on the sensors) change, of course the gain will change correspondingly.

In an advantageous embodiment the pulse height is determined by successively sampling the pulse amplitude, where the pulse height is determined by the maximum measured amplitude value. For this purpose only the present amplitude value as to be compared with the previous one. If the previous one is smaller, obviously the peak of the pulse has not been reached. When the successive value is equal to the previous one or even smaller, the peak has been reached or passed. This value then is further processed as the pulse height. Corresponding electronical equipment with adequate speeds for such a process is available.

A much simpler way of measuring the pulse height which does not require high speed electronics of such a high quality consists in that the pulse height is determined by measuring the pulse height at the moment when the derivative of the pulse signal goes through zero.

As is well known, the derivative of a pulse signal is zero at the position of the pulse peak. To obtain the derivative of the pulse signal does not present any difficulties at all, such that the pulse height can be determined easily.

In order to determine the position of the zero derivative and thus the pulse peak more accurately the derivative in an advantageous embodiment is amplified into a square wave function.

Sometimes the pulses will not contain only one peak, but also additional peaks. This will be the case e.g. if spots on the beans are present which ae much darker or much brighter than the remaining surface of the bean. If also such additional peaks are recorded and processed, further results about the quality of the beans can be obtained. If this information is also used for sorting the beans, a product of higher quality can be obtained.

Advantageously the number of pulses is determined only from the number of main peaks of the pulses. By amplifying and evaluating also the negative portion of the derivative of the pulse signal as a square wave further information can be obtained, e.g. about secondary peaks and thus defects (spots) of the samples in this portion. Thus the derivative here is hidden within the noise. If, however, also the negative portion of the derivative is used, also this secondary peak can be detected.

Because the signals normally are fed to the circuit via at least one input capacitor, the DC zero level is shifted by the pulse signals. In order to remove the ambiguities of an uncertain DC level, advantageously the DC level of the pulse signal is restored to its original value before an input capacitor of the circuit.

As mentioned above, the sorting device has to be activated with a delay which corresponds to the flight time of the samples, e.g. the beans, from the detectors to the sorting device. This time of flight can be different for different beans, depending on the shape of the beans, whether they just have touched the walls, etc. Therefore, a certain danger exists that much faster or much slower samples are not sorted out properly. In order to avoid these problems which can be achieved with means anyhow provided for the inventive process or in the inventive apparatus, detectors or sets of detectors can be used, which are arranged in a distance with respect to each other in the direction of movement of the samples. The time-wise distance of the peaks of the corresponding pulses is measured and used for determining the delay with which the sorting device is activated after the sample has passed the detectors.

An apparatus for performing the process is characterized in that it comprises a device for determining the pulse height of every signal, a counting means for counting pulse with pulse heights within a predetermined range, a counting means for counting the total number of pulses, means for comparing these numbers and means for adjusting the gain as a result of these numbers.

The invention in the following is further explained with reference to the accompanying drawings in which:

Fig. 1a shows a typical wave form of pulses occurring when performing the inventive process;

Fig. 1b shows the derivative of the signals of Fig. 1a;

Fig. 1c shows the square wave signal obtained from the derivative of Fig. 1b;

Fig. 2a to 2c in a similar way as in Fig. 1 show the signal, the derivative signal and the square signal obtained from the derivative;

Fig. 3a shows schematically two spaced sets of detectors;

Fig. 3b shows the pulse signal originating from the detector arrangement of Fig. 3a;

Fig. 4 shows the wave form of a pulse for showing the effect of the inventive measures in order to restore the DC level; and

Fig. 5 shows a simple circuit for obtaining the result indicated in Fig. 4.

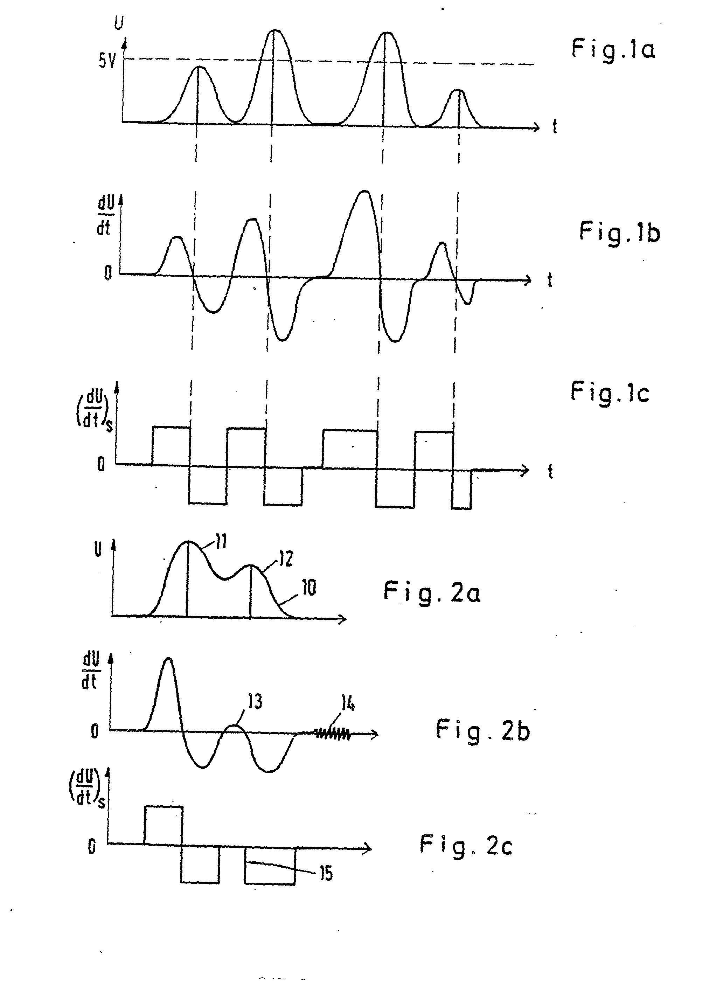

In Fig. 1a a sequence of pulses is shown, in which the peak values of the pulses are indicated by straight lines. These peak values are determined by measuring the pulse amplitude at the moment when the derivative dU/dt of Fig. 1b goes through zero. This point where the derivative goes through zero is determined more accurately with the wave form $(dU/dt)_s$ of Fig. 1c, which was

obtained from the derivative of Fig. 1b by amplification up to saturation.

The usefulness of this squared wave form (du/dt)$_s$ is more clearly shown in Fig. 2a, where the pulse 10 has two peaks, i.e., a main peak 11 and a secondary peak 12 which might be due to the fact that at the bean corresponding to the pulse 10 has a spot on its surface.

As can be seen in Fig. 2b the very flat secondary peak results only to a very small positive portion 13 of the derivative signal dU/dt. This small positive portion can be completely hidden in the noise which is indicated at 14.

If, however, also the negative portion of the square wave form is amplified and used, the position of peak 12 can nevertheless be detected with aid of part 15 of the square wave form, where the signal quickly drops from zero to the maximum negative value.

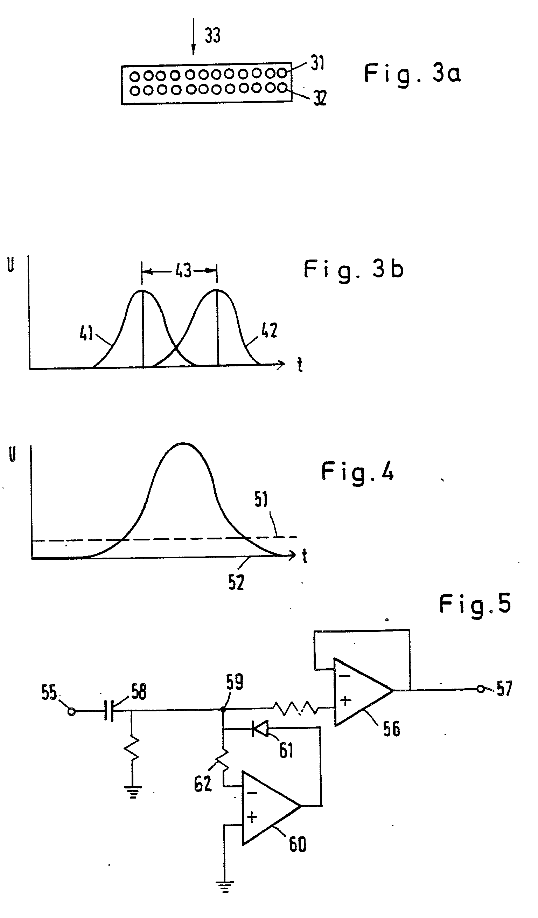

In the embodiment of Fig. 3a two sets of detectors 31 and 32 are shown which are spaced with respect to each other in the direction 33 of movements of the samples. As can be seen in Fig. 3b detectors 31 produce a pulse 41 whereas detector 32 produce a pulse 42. The time-wise difference of these pulses, which is indicated at 43, is a measure for the speed of the sample. This time-wise difference 43 can be accurately determined by again determining the point when the respective derivatives of the pulses go through zero.

In Fig. 4 a pulse signal is shown in which the DC zero level is shifted to the level indicated by broken line 51 due to the effects of at least one capacitor which normally is present in the signal path. By adding the absolute value of the negative part of the signal to same a signal is obtained, the DC zero voltage level of which is restored to the original one (the solid line indicated at 52). Thus, the pulse height can be determined without the ambiguities of an uncertain DC level.

A simple circuit for obtaining this result is shown in Fig. 5. The signal enters at terminal 55 and leaves the circuit after passing through a buffer amplifier 56 at terminal 57. Due to the input capacitor 58 of this circuit the DC zero level is shifted as indicated at 51 in Fig. 4. A point 59 of the signal path between capacitor 58 and buffer amplifier 56 is connected to the minus input of an amplifier 60 via a resistor 62. The plus input of amplifier 60 is grounded or connected to a reference DC voltage. The output of amplifier 60 is connected to the anode of diode 61, the cathode of which is connected to point 59.

## Claims

1. Process for sorting samples of a material, in which a pulse signal from each sample reaches a detector, where the signal then is electronically processed in a signal processing device to activate a sorting device if the signal has predetermined properties and where the gain of the device for processing the signal is adjustable by using peak values of the pulses, characterized in that the gain is automatically and continuously controlled by measuring peak values of the pulses (10, 41, 42), by counting the pulses with pulse heights within a certain predetermined range, by counting the total number of pulses, and by readjusting the gain if the ratio of number of pulses (10, 41, 42) within the predetermined range to the total number of pulses deviates from a predetermined ratio.

2. Process according to claim 1, characterized in that all pulses (10, 41, 42) with heights above a predetermined magnitude are counted and compared with the total number of pulses (10, 41, 42).

3. Process according to claim 1 or 2, characterized in that the pulse height is determined by successively sampling the pulse amplitude, where the pulse height is determined by the maximum measured amplitude value.

4. Process according to claim 1 or 2, characterized in that the pulse height is determined by measuring the pulse height at the moment when the derivative of the pulse signal goes through zero.

5. Process according to claim 4, characterized in that the derivative is amplified into a square wave function.

6. Process according to any one of claims 1 to 5, characterized in that also additional peaks (11, 12) of the pulses (10) are recorded.

7. Process according to claim 5 or 6, characterized in that the number of pulses (10) is determined only from the number of main peaks (11) of the pulses (10), and that also the negative portion of the derivative of the pulse signal is amplified into a square wave and evaluated.

8. Process according to any one of claims 1 to 7, characterized in that the DC level of the pulse signal is restored to its original value before an input capacitor (58) of the circuit.

9. Process according to any one of claims 1 to 8, characterized in that two detectors or sets of detectors (31, 32) are used, which are arranged in a distance with respect to each other in the direction (33) of movement of the samples, that the time-wise distance of the peaks of the corresponding pulses (10, 41, 42) is measured and used for determining the delay with which the sorting device is activated after the sample has passed the detectors.

10. Apparatus for performing the process according to any of the claims 1 to 9, comprising detector means for detecting pulse signals from each sample, electronic processing means for the detector signals, the gain of which is adjustable using peak values of the pulses, and a sorting device responsive to the output signals of the processing means, characterized in that it comprises a device for determining the pulse height of every signal, a counting means for counting pulses with pulse heights within a predetermined range, a counting means for counting the total number of pulses, means for determining the ratio of these numbers and means for automatically and continuously adjusting the gain as a result of these numbers.

## Patentansprüche

1. Verfahren zum Sortieren von Proben eines Materials, bei dem ein Pulssignal von jeder Probe einen Detektor erreicht, wo das Signal dann in einer Signalverarbeitungseinrichtung elektronisch verarbeitet wird, um eine Sortiereinrichtung zu aktivieren, wenn das Signal vorbestimmte Eigenschaften hat, und wobei die Verstärkung der Einrichtung zum Verarbeiten des Signals unter Verwendung von Spitzenwerten der Pulse einstellbar ist, dadurch gekennzeichnet, daß die Verstärkung automatisch und kontinuierlich geregelt wird, indem Spitzenwerte der Pulse (10, 41, 42) gemessen werden, indem die Pulse mit Pulshöhen innerhalb eines gewissen vorbestimmten Bereiches gezählt werden, indem die Gesamtanzahl der Pulse gezählt wird, und indem die Verstärkung neu eingestellt wird, wenn das Verhältnis der Anzahl von Pulsen (10, 41, 42) innerhalb des vorbestimmten Bereichs zur gesamten Anzahl von Pulsen von einem vorbestimmten Verhältnis abweicht.

2. Verfahren nach Anspruch 1, dadurch gekennzeichnet, daß alle Pulse (10, 41, 42) mit Höhen oberhalb einer vorbestimmten Größe gezählt werden und mit der gesamten Anzahl von Pulsen (10, 41, 42) verglichen werden.

3. Verfahren nach Anspruch 1 oder 2, dadurch gekennzeichnet, daß die Pulshöhe dadurch bestimmt wird, daß die Pulsamplitude fortlaufend abgetastet wird, wobei die Pulshöhe durch den größten gemessenen Amplitudenwert bestimmt wird.

4. Verfahren nach Anspruch 1 oder 2, dadurch gekennzeichnet, daß die Pulshöhe dadurch bestimmt wird, daß die Pulshöhe in dem Moment gemessen wird, wenn die Ableitung des Pulssignals durch null geht.

5. Verfahren nach Anspruch 4, dadurch gekennzeichnet, daß die Ableitung in eine Rechteckwellenfunktion verstärkt wird.

6. Verfahren nach einem der Ansprüche 1 bis 5, dadurch gekennzeichnet, daß auch zusätzliche Spitzen (11, 12) der Pulse (10) aufgezeichnet werden.

7. Verfahren nach Anspruch 5 oder 6, dadurch gekennzeichnet, daß die Anzahl von Pulsen (10) nur von der Zahl der Hauptspitzen (11) der Pulse (10) bestimmt wird, und daß auch der negative Teil der Ableitung des Pulssignals in eine Rechteckwelle verstärkt und ausgewertet wird.

8. Verfahren nach einem der Ansprüche 1 bis 7, dadurch gekennzeichnet, daß der Gleichspannungspegel des Pulssignals auf seinen ursprünglichen Wert vor einem Eingangskondensator (58) der Schaltung zurückgebracht wird.

9. Verfahren nach einem der Ansprüche 1 bis 8, dadurch gekennzeichnet, daß zwei Detektoren oder Sätze von Detektoren (31, 32) verwendet werden, die in einer Entfernung in bezug aufeinander in der Richtung (33) der Bewegung der Proben angeordnet sind, daß der zeitliche Abstand der Spitzen der entsprechenden Pulse (10, 41, 42) gemessen und zum Bestimmen der Verzögerung verwendet wird, mit der die Sortiereinrichtung aktiviert wird, nachdem die Probe sich an den Detektoren vorbeibewegt hat.

10. Vorrichtung zur Durchführung des Verfahrens nach einem der Ansprüche 1 bis 9, die Detektormittel zum Detektieren von Pulssignalen von jeder Probe, elektronische Verarbeitungsmittel für die Detektorsignale, deren Verstärkung unter Verwendung von Spitzenwerten der Pulse einstellbar ist, und eine Sortiereinrichtung aufweist, die auf die Ausgangssignale der Verarbeitungsmittel reagiert, dadurch gekennzeichnet, daß sie eine Einrichtung zum Bestimmen der Pulshöhe jedes Signals, ein Zählmittel zum Zählen von Pulsen mit Pulshöhen innerhalb eines vorbestimmten Bereichs, ein Zählmittel zum Zählen der gesamten Anzahl der Pulse, Mittel zum Bestimmen des Verhältnisses dieser Anzahlen und Mittel zum automatischen und fortdauernden Einstellen der Verstärkung als Ergebnis dieser Anzahlen aufweist.

## Revendications

1. Procédé de triage d'échantillons d'une matière, dans lequel un signal impulsionnel en provenance de chaque échantillon atteint un détecteur, où le signal est alors traité électroniquement dans un dispositif de traitement du signal, pour activer un dispositif de triage si le signal a des propriétés prédéterminées et où le gain du dispositif de traitement du signal est réglable au moyen des valeurs de crête des impulsions, caractérisé en ce que le gain est commandé de façon automatique et continue par la mesure de valeurs de crête des impulsions (10, 41, 42), par le comptage des impulsions ayant des hauteurs d'impulsion dans une certaine gamme prédéterminée, par le comptage du nombre total d'impulsions et par le réajustement du gain si le rapport du nombre d'impulsions (10, 41, 42) dans la gamme prédéterminée au nombre total d'impulsions s'écarte d'un rapport prédéterminé.

2. Procédé selon la revendication 1, caractérisé en ce que toutes les impulsions (10, 41, 42) ayant des hauteurs au-dessus d'une grandeur prédéterminée sont comptées et comparées avec le nombre total d'impulsions (10, 41, 42).

3. Procédé selon la revendication 1 ou 2, caractétisé en ce que la hauteur des impulsions est déterminée par échantillonnage successif de l'amplitude des impulsions, la hauteur des impulsions étant déterminée par la veleur d'amplitude maximale mesurée.

4. Procédé selon la revendication 1 ou 2, caractérisé en ce que la hauteur des impulsions est déterminée par la mesure de la hauteur des impulsions au moment où la dérivée du signal impulsionnel passe par zéro.

5. Procédé selon la revendication 4, caractérisé en ce que la dérivée est amplifiée en une fonction à onde rectangulaire.

6. Procédé selon l'une quelconque des revendications 1 à 5, caractérisé en ce que des crêtes additionnelles (11, 12) des impulsions (10) sont également enregistrées.

7. Procédé selon la revendication 5 ou 6, caractérisé en ce que le nombre d'impulsions (10) n'est déterminé qu'à partir du nombre de crêtes principales (11) des impulsions (10), et en ce que la partie négative de la dérivée du signal impulsionnel est également amplifiée en une onde rectangulaire et évaluée.

8. Procédé selon l'une quelconque des revendications 1 à 7, caractérisé en ce que le niveau de courant continue du signal impulsionnel est ramené à sa valeur primitive avant un condensateur d'entrée (58) du circuit.

9. Procédé selon l'une quelconque des revendications 1 à 8, caractérisé en ce qu'il est utilisé deux détecteurs ou jeux de détecteurs (31, 32) qui sont disposés à distance l'un de l'autre dans la direction (33) de mouvement des échantillons, en ce que la distance dans le temps des crêtes des impulsion correspondantes (10, 41, 42) est mesurée et utilisée pour déterminer le retard avec lequel le dispositif de triage est activé après que l'échantillon est passé devant les détecteurs.

10. Appareil pour l'exécution du procédé selon l'une quelconque des revendications 1 à 9, comprenant des moyens détecteurs pour détecter des signaux impulsionnels en provenance de chaque échantillon, des moyens de traitement électronique pour les signaux du détecteur, dont le gain est réglable au moyen des valeurs de crête des impulsions, et un dispositif de triage qui répond aux signaux de sortie des moyens de traitement, caractérisé en ce qu'il comprend un dispositif pour déterminer la hauteur d'impulsion de chaque signal, des moyens de comptage pour compter les impulsions dont la hauteur d'impulsion se situe dans une gamme prédéterminée, des moyens de comptage pour compter le nombre total d'impulsions, des moyens pour déterminer le rapport de ces nombres et des moyens pour régler le gain de façon automatique et continue en conséquence de ces nombres.

EP 0 178 341 B1

Fig.1a

Fig.1b

Fig.1c

Fig.2a

Fig.2b

Fig.2c

33

Fig. 3a

31

32

U

|←43→|

41          42

t

Fig. 3b

U

51

52

t

Fig. 4

Fig. 5

55    58    59

57

56

61

62

60